# EUROPEAN PATENT SPECIFICATION

(11) **EP 1 783 246 B1**
(45) Date of publication and mention of the grant of the patent: **30.04.2014**
(21) Application number: 06122188.3
(22) Date of filing: 12.10.2006
(51) Int. Cl.: C23C 14/24, G21K 4/00, C23C 14/06, C09K 11/61

(54) **Method of preparing stabilised storage phosphor panels.**
Verfahren zur Stabilisierung von Speicherleuchtschirmen
Procédé de stabilisation de panneaux de stockage phosphorescents

(30) Priority: 28.10.2005 EP 05110124; 28.10.2005 EP 05110119; 28.10.2005 EP 05110120; 28.10.2005 EP 05110122
(43) Date of publication of application: 09.05.2007
(73) Proprietor: Agfa HealthCare N.V., 2640 Mortsel (BE)
(72) Inventor: Tahon, Jean-Pierre, 2640, Mortsel (BE); Leblans, Paul, 2640, Mortsel (BE)
(74) Representative: Theunis, Patrick

(56) References cited:
- EP-A1- 1 460 642

## Description

### FIELD OF THE INVENTION

The present invention relates to a method of preparing a vapour deposited storage phosphor plate. More particularly the invention is related with a method providing stabilization of speed of said storage phosphor plate as a function of time, even in the absence of any surface protective layer thereupon, wherein said storage phosphor is present in a binderless needle-shaped phosphor layer having a matrix component which is normally very sensitive to environmental humidity.

### BACKGROUND OF THE INVENTION

A well-known use of phosphors is in the production of X-ray images. In a conventional radiographic system an X-ray radiograph is obtained by X-rays transmitted image-wise through an object and converted into light of corresponding intensity in a so-called intensifying screen or X-ray conversion screen wherein phosphor particles absorb the transmitted X-rays and convert them into visible light and/or ultraviolet radiation to which a photographic film is more sensitive than to the direct impact of X-rays.

According to another method of recording and reproducing an X-ray pattern as disclosed e.g. in US-A 3,859,527 a special type of phosphor is used, known as a photostimulable phosphor, which being incorporated in a panel, is exposed to incident pattern-wise modulated X-ray beam and as a result thereof temporarily stores energy contained in the X-ray radiation pattern. At some interval after the exposure, a beam of visible or infra-red light scans the panel to stimulate the release of stored energy as light that is detected and converted to sequential electrical signals which can be processed to produce a visible image. For this purpose, the phosphor should store as much as possible of the incident X-ray energy and emit as little as possible of the stored energy until stimulated by the scanning beam. This is called "digital radiography" or "computed radiography".

In both kinds of radiography it is preferred to be able to choose the phosphor that will be used on the basis of its speed and image quality without having to bother about its sensitivity for external influences as temperature and humidity, thereby reckening upon a long lasting life-time.

Sensitivity to humidity, in particular, is known to apply e.g. for alkali metal salts. As photostimulable or storage phosphors making use of such salts as matrix components have regained an enhanced interest during the last five years as is e.g. illustrated in US-A 6,802,991 , it is clear that one of the first problems to overcome was to protect such a storage phosphor plate from moisture by covering said panel with a protective layer, e.g. with a moistureproof parylene (poly-p-xylylene) layer as in US-A 6,710,356 and in US-Applications 2003/0038249 and 2005/0040340; with a water-repellent layer as in US-Application 2004/0183029 or by a sealing procedure as in US-Application 2003/0152692.

Further measures related therewith in order to optimise said protection have been disclosed in US-Applications 2005/0067584, by providing more protective layers as in US-A 6,822,243 and in US-Applications 2003/0146395 and 2003/0151001 and/or to provide a packaging for such panels as has been described in US-Application 2004/0070328. As a material used in the protective layer, and e.g. laminated thereto, polyalkylene film, polyester film, poly-methacrylate film, nitrocellulose film, cellulose acetate film and the like may be used and, for example, polypropylene film, polyethylene terephthalate film, polyethylene naphthalate film and the like are preferable from the aspect of transparency and strength. As the protective layer, a material having low permeability of moisture and oxygen, e.g. a film on which silica and/or alumina is deposited as described in US2004/0108464.

As is known very well by anyone skilled in the art and as is acknowledged in US-Application 2005/0145808 the regression of a latent image becomes fast when the photostimulable phosphor absorbs moisture. As a consequence it would be desirable to have very suitable tools, in order to provide intrinsic protection against moisture for the phosphor in itself, before application of external protective measures against moisture afterwards, without however to neglect external protective measures as a sufficient resistance against physical damage during use of said storage phosphor panel is still required.

With respect to vapour deposition techniques, in US-A 7,070,658 information has been given about particular parts in the vapour deposition unit, in order to reach the object of further improving homogeneity of the phosphor or scintillator sheets or panels, which may be provided with a moisture-resistant layer against deterioration of alkali halide based storage phosphors, before or after cutting the large sheets or panels in desired formats.

Apart from some particular crucible configurations with a convection member and an indication about a substrate temperature of about 120°C, substrate whereupon vapour deposition should be performed, no indication can be found about improving humidity stability of alkali halide based phosphors in US-A 2005/0103273.

In EP-A 1 568 751 and corresponding US-A 2005/186329 no specifically detailed information has further been given with respect to temperatures in the crucibles either: apart for providing a method for producing a binderless phosphor screen or panel by the steps of providing a CsX:Eu phosphor by depositing said phosphor on a substrate, in this reference an improvement for resistance to moisture of the produced CsBr:Eu screens or panels has been given by making use of selected stable CsₓEu_{y}X'_{x+αy} complexes as starting components for performing the vapour deposition process.

None of these references however specifically relates to other means apart from external protective coatings or stable starting raw materials to further improve phosphor stability with respect to moisture sensitivity, thus making decrease storage phosphor screen speed to a lesser extent, i.e. to maintain high screen speed in a better way than made possible hitherto.

It is thus an object of the present invention to provide a binderless needle-shaped storage phosphor panel, wherein a doped alkali halide phosphor, and more particularly, a CsBr:Eu phosphor yield screens combining good intrinsic humidity resistance, a high, nearly constant speed over a long use time period and an ever lasting good image quality.

### SUMMARY OF THE INVENTION

The above-mentioned advantageous effects are realized by providing a method, the preparation steps of which are set out in claim 1, thereby enforcing built-in of said dopant or activator for increasing the intrinsic humidity stability of a storage phosphor panel having a phosphor layer coated onto a dedicate substrate by vapour depositing raw phosphor precursor materials of a matrix and a dopant or activator component and/or a combination thereof from one or more crucible unit(s), wherein a crucible unit at least comprises a crucible container and a vaporisation chimney.

More particular features for preferred embodiments of the invention are set out in the dependent claims.

Further advantages and embodiments of the present invention will become apparent from the following description and from the drawings.

### DEFINITION

The term "activator coating weight number" (ACWN) is defined herein as the product of the average activator amount present in said phosphor layer, said amount being expressed in p.p.m. (µg/g) of activator versus matrix component, and weight of coated phosphor in said phosphor layer, expressed in mg/cm².

### BRIEF DESCRIPTION OF THE DRAWINGS

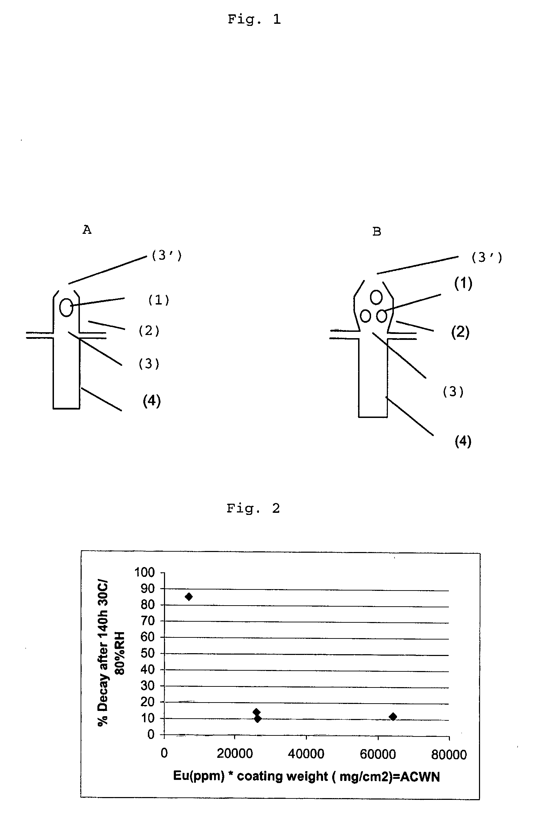

Fig. 1 shows chimney heaters (1), an internally heated chimney (2), a chimney inlet (3) and outlet (3') and a crucible, tray or boat (4), wherein in configuration A only one lamp is present as a longitudinal heating element, and wherein in configuration B three lamps are present as a longitudinal heating elements, arranged in order to act as baffles, thereby avoiding spatter from the crucible unit onto a support material for the phosphor layer to be vapour deposited.
Fig. 2 is illustrative for decay percentages for storage phosphor plates as a function of "activator coating weight number" (product of Eu content in p.p.m. and coating weight of phosphor in mg/cm²) when stored - without any protective layer - in a conditioning room at 30°C and 80% relative humidity during 140 hours.

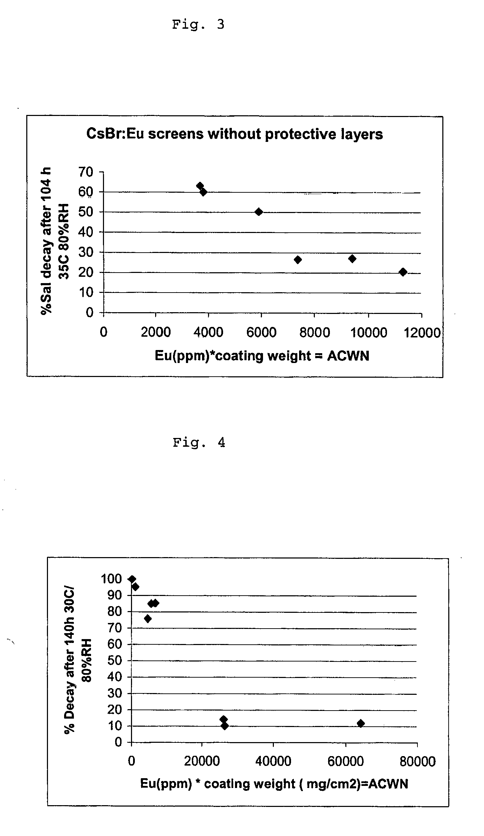

Fig. 3 shows speed decay percentages as measured for storage phosphor screens with CsBr:Eu phosphor layers after conditioning during 104 hours in an atmosphere of 30°C and a relative humidity of 80% as a function of the product of Eu-activator amount (in p.p.m.) and coated weight (in mg/cm²) for an unprotected CsBr:Eu needle-shaped phosphor layer, vapour deposited onto a support of a storage phosphor plate of panel and wherein said panel is particularly suitable for use in mammographic applications.
Fig. 4 shows the speed percentage decay after conditioning during 140 hours in an atmosphere of 30°C and a relative humidity of 80% as a function of the product of Eu-activator amount (in p.p.m.) and coated weight (in mg/cm²) for an unprotected CsBr:Eu needle-shaped phosphor layer, vapour deposited onto a support of a storage phosphor plate of panel and wherein said panel is particularly suitable for use in general radiographic applications.

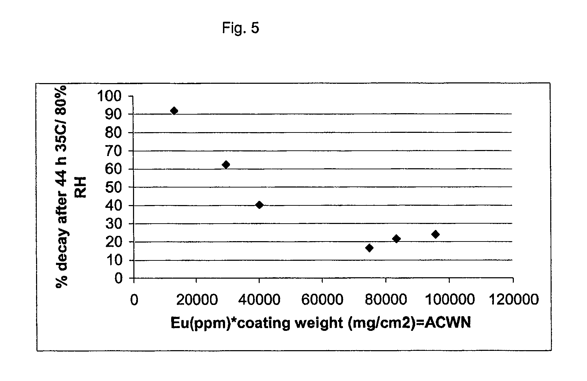

Fig. 5 represents speed decay percentages after conditioning during 44 hours in a more severe atmosphere of 35°C and a relative humidity of 80% as a function of the calculated "activator coating weight number" (ACWN) defined above.

### DETAILED DESCRIPTION OF THE INVENTION

As an advantageous effect of the present invention it has unexpectedly been found that, for the same coating amount of phosphor in a vaporisation process, modified according to the method of the present invention, phosphor speed is maintained in that its intrinsic humidity stability, expressed as a speed loss strived after to be less than 20 % after an ageing procedure during a long time in an atmosphere having a relative high temperature and a high (tropic) humidity, without providing one or more protective layer(s) for that vapour deposited binderless phosphor.

In a method of preparing a storage phosphor panel having a phosphor layer coated onto a dedicate substrate by vapour depositing raw phosphor precursor materials comprising a matrix component, an activator component and/or a combination thereof, from one or more crucible unit(s) in a vapour deposition apparatus, wherein said crucible unit comprises a crucible container and a vaporisation chimney; said method thus comprises the steps of (1)adding said raw phosphor precursor materials to said crucible unit, and (2)vapour depositing a phosphor layer from said raw phosphor precursor materials, wherein vapour depositing proceeds at an increased temperature in the crucible unit, said temperature exceeding the melting temperature of said matrix raw material with more than 70°C; characterised in that an "activator coating weight number" for said phosphor layer reaches a value of at least 7,000; said "activator coating weight number" being defined as product of average activator amount present in said phosphor layer, said amount being expressed in p.p.m. (µg/g) of activator versus matrix component, and weight of coated phosphor in said phosphor layer, expressed in mg/cm².

The preparation method is performed by making use of one crucible unit or more crucible units.

In one embodiment according to the method of the present invention said "activator coating weight number" reaches a value of at least 7,000.

This is more particularly the case when in the method according to the present invention an average activator amount present in said phosphor layer is at least 70 p.p.m..

In the method according to the present invention said weight of coated phosphor is less than 100 mg/cm² and said phosphor layer has an average thickness of less than 200 µm. This is advantageously the case, more particularly, when storage phosphor panels suitable for use in mammographic applications are envisaged.

In another embodiment according to the method of the present invention vapour deposition of a phosphor layer is provided wherein an "activator coating weight number" reaches a value of more than 20,000; more preferably a value of more than 40,000; and still more prefably said "activator coating weight number" reaches a value of more than 60,000.

In the method of the present invention this is more particularly the case when an average activator amount present in said phosphor layer is at least 200 p.p.m..

In that case in the method according to the present invention the weight of coated phosphor is at least 100 mg/cm² and said phosphor layer has an average thickness of at least 200 µm.

This second embodiment is advantageously the case, more particularly, when storage phosphor panels suitable for use in general radiographic applications are envisaged.

Exceeding the melting temperature of said matrix raw material with more than 70°C means that in a preferred embodiment said temperature in said crucible container is at least increased 75°C versus said melting temperature, and even at least 80°C, i.e., 5°C and 10°C respectively versus a reference temperature, set 70°C higher than the melting temperature of the matrix raw material. In praxis a temperature difference of about 80°C versus the melting temperature of said matrix raw material precursor component or compound is envisaged.

In a particular embodiment a further step of increasing the temperature in a vaporisation chimney of said crucible unit(s) versus the temperature in said crucible container and maintaining a positive temperature difference is applied.

According to the present invention, said method further includes a step of increasing the temperature in a vaporisation chimney of the crucible unit(s) versus the temperature in the crucible container wherein enhancing said temperature in the vaporisation chimney of the crucible unit versus in the crucible containing raw material precursor(s) proceeds by the step of heating said raw precursor materials in the boat or crucible in liquid form up to a temperature T1 and by heating said raw material precursor(s) in vaporised form in said chimney up to a temperature T2 and wherein a positive difference in temperature [T2 - T1] is maintained. Said temperatures are preferably controlled by means of thermo-couples. More particularly said temperatures are controlled and steered by means of thermo-couples, while steering said temperatures by means of thermo-couples advantageously proceeds by a back-coupling mechanism. Furtheron a set of coupled thermo-couples is preferably present in the raw materials covering the bottom of the said crucible. It is particularly preferred that a set of coupled thermo-couples is present at the outside of the crucible, in contact with the bottom of said crucible in order to measure and steer temperature T1. Moreover it is particularly preferred that a set of coupled thermo-couples is present in the vaporised raw materials in the said chimney in order to measure and steer temperature T2.

In the method of the present invention, as a parent or matrix component M¹X.aM²X'₂.bM³X"₃ is used, wherein M represents an alkali metal selected from the group consisting of Li, Na, K, Rb and Cs; wherein M² represents a divalent metal selected from the group consisting of Be, Mg, Ca, Sr, Ba, Zn, Cd, Cu and Ni; M³ represents a trivalent metal selected from the group consisting of Sc, Y, La, Ce, Pr, Nd, Pm, Sm, Eu, Gd, Tb, Dy, Ho, Er, Tm, Yb, Lu, Al, Ga and In; X, X' and X" each represent a halogen selected from the group consisting of F, Cl, Br and I; a and b each represent 0 ≤ a < 0.5 and 0 ≤ b < 0.5, and as an activator component A, wherein A represents a metal selected from the group consisting of Eu, Tb, Bi, In, Ga, Cs, Ce, Tm, Dy, Pr, Ho, Nd, Yb, Er, Gd, Lu, Sm, Y, Tl, Na, Ag, Cu and Mg.

With respect to the coated phosphor to be obtained in the vapour depositing apparatus wherein the method of the present invention is applied, said phosphor, in one embodiment, is a photostimulable phosphor. As a very interesting photostimulable (storage) phosphor that is successfully deposited in the vapour depositing apparatus wherein the method of the present invention is applied, CsBr:Eu phosphor has been selected. Raw materials used in the preparation of CsBr:Eu storage phosphor plates or panels are CsBr as a matrix component and between 10⁻³ and 5 mol % of a Europium compound as a dopant or activator component, wherein said Europium compound is selected from the group consisting of EuX'₂, EuX'₃ and EuOX', X' being a halide selected from the group consisting of F, Cl, Br and I as has been used in the preparation method disclosed in PCT-filing WO 01/03156. Even more preferred is a binderless coating of the selected CsBr:Eu phosphor from CsBr and EuOBr raw materials, wherein the said phosphor is characterised by its particular needle-shaped form. The high crystalline degree of said storage phosphor is easily analysed by X-ray diffraction techniques, providing a particular XRD-spectrum as has been illustrated in US-Application 2001/0007352.

In one particular embodiment of the method according to the present invention CsX accordingly is a matrix component and EuX₂, EuX₃, EuOX or a mixture thereof are activator components, X representing Cl, Br, I or a combination thereof.

In another particular embodiment of the method according to the present invention CsₓEu_{y}X'_{(x+αy)} is an activator precursor material, wherein x, y and α are integers, wherein x/y is more than 0.25 and wherein α is at least 2 and wherein X' represents Cl, Br, I or a combination thereof.

In one practical embodiment in the vapour depositing apparatus wherein the method of the present invention is applied, the procedure starts with adding mixed raw materials in the crucible(s) comprising, as phosphor precursors, at least CsₓEu_{y}X'_{(x+αy)} as an activator precursor material as defined hereinbefore.

In another practical embodiment a mixture of raw materials e.g. comprises, as phosphor precusors, at least CsBr and CsₓEu_{y}X'_{(x+αy)}. as in US-Applications 2005/0184250 and 2005/0186329.

According to the method of the present invention a storage phosphor panel is provided, wherein said storage phosphor is CsBr:Eu. When preparing such a CsBr:Eu storage phosphor panel by vapour deposition temperature T1, mentioned hereinbefore, is recommended to be higher than 640°C, preferably at least 680°C, while vapour depositing the desired CsBr:Eu phosphor. Furtheron temperature T2 as defined hereinbefore should be higher than 640°C in order to maintain a positive temperature difference with T1. In such practical vapour depositions in order to prepare the desired CsBr:Eu storage phosphor panel, T1 should e.g. at least be 710°C; and in an even more preferred embodiment at least 720°C, wherein temperatures higher than 750°C are not excluded. Accordingly T2 should be at least be higher than 750°C and more preferably in the range from 800°C - 850°C. In a more particular embodiment in the method according to the present invention a difference in temperature [T2 - T1] of at least 80°C is maintained. Even a temperature difference up to 130°C, i.e. a range of 50°C in excess, should advantageously be maintained.

With respect to the pressure maintained in the vacuum depositing apparatus, it is recommended to proceed in an inert atmosphere, preferably an Ar-atmosphere, with a pressure from 0.01 to at most 3 Pa.

The method according to the present invention thus provides an increased humidity stability, which is determined by measuring a loss in speed of said of panel of less than 20 % over a time period of 140 hours in a room conditioned at a temperature of 30°C and at 80 % of relative humidity, and even more preferred, less than 15 %.

In one embodiment according to the method of the present invention, said vapour deposition proceeds in a batch process.

In another embodiment according to the method of the present invention, said vapour deposition proceeds in a continuous process.

Further details about how continuous and batch vapour deposition processes may be performed, can be found in EP-A 1 460 642 and EP-A 1 460 643 and corresponding US-Applications 2004/0219289 and 2004/0224084; and in US-A 6,802,991 respectively.

Multi-evaporation is further defined herein as evaporating from one and the same crucible or crucibles, in multiple consecutive evaporation steps, raw precursor materials or combinations thereof having the same or a different composition while performing said multiple consecutive evaporation steps. Said consecutive steps are characterised by one or more steps of adding said raw materials or combinations thereof in order to compensate for exhaustion of the crucible content as a consequence of progressively vapour depositing said raw materials as precursors for phosphor vapour deposition. In order to save time it is understood that between consecutive vaporisation steps, no cleaning of empty or nearly empty crucible(s) takes place. Reason why this kind of "replenishment" of the crucibles is sometimes required, is related with the total volume of the crucible, the volume up to which the said crucible may be filled with raw materials (in order to avoid e.g. spatter) and the coating thickness of the phosphor layer onto the substrate or support whereupon said phosphor should be deposited by the vapour deposition process. Replenishment may alternatively be performed as described in US-A 2004/0224084 wherein it has been established that, even when no change in composition in the thickness direction is desired, it is clear that the crucible(s) become(s) exhausted during the physical vapour deposition process and that "replenishment" of the crucible(s) should be provided, e.g. by addition of raw material components in powdery form, in form of grains or crystals or in form of pastilles containing caked powder or grain mixtures, in favour of maintaining homogeneity during the further evaporation process as otherwise, differences in dopant (Europium) concentrations may appear, while the coating process is running furtheron. Methods referred to and applicable in order to "replenish" the crucible(s) have e.g. been described in US-A 4,430,366, in DE-A 1 98 52362 and in US-A 2003/0024479.

According to the method of the present invention a step of multi-evaporation is performed by replenishing said crucible(s) without a cleaning step in between. Advantages offered by adding a multi-evaporation step are thus related with the ability to deposit more phosphor, which is important when large substrate surfaces must be covered. Apart therefrom a change in composition can be made possible in that e.g. multiple additions of gradually changing compositions of raw mixtures of matrix component and activator component may lead to gradually changing amounts of dopant or activator from the substrate to the top of the deposited phosphor layer.

Annealing is further known as a procedure wherein an additional energy treatment is given after the end of the vapour deposition. Most performed as an additional energy treatment is a heat treatment, which is performed after vapour deposition. Annealing procedures, as in US-A 6,730,243 may be applied wherein after cooling the plate is brought to a temperature between 80 and 220°C and maintained at that temperature for a time between 10 minutes and 15 hours. In another embodiment as in US-A 2003/186023 a procedure may be applied wherein heating the phosphor layer proceeds at a temperature of lower than 300°C but not lower than 50°C for a period of 1 to 8 hours in an inert gas atmosphere or an inert gas atmosphere containing a small amount of oxygen or hydrogen. Furtheron as in US-A 2003/0218139 annealing may be performed at a temperature of 50 to 600°C for at least one hour. As in US-A 2005/0040340 an annealing step may be performed at a temperature of from 80°C to 300°C, and more preferably from 100°C to 200°C. Moreover as described in US-A 2005/0133731 after the deposition procedure is complete, the deposited layer may be subjected to heat treatment (annealing), which is carried out generally at a temperature of 100 to 300°C for 0.5 to 3 hours, preferably at a temperature of 150 to 250°C for 0.5 to 2 hours, under inert gas atmosphere which may contain a small amount of oxygen gas or hydrogen gas. Alternatively as in EP-A 1 443 525 and in US2005/0077477 a radiation exposure treatment may be given with energy from radiation sources emitting short ultraviolet radiation in the range from 150 nm to 300 nm with an energy of at least 10 mJ/mm². Most performed as an additional energy treatment is a heat treatment, performed after vapour deposition. So as an annealing step a heat treatment is advantageously performed after vapour deposition, e.g., at 170°C during a time of 4 hours.

As an advantageous effect of the present invention it has unexpectedly been found that for the same coating amount of phosphor in a vaporisation process, modified according to the method of the present invention, an enhanced phosphor speed is measured for the storage phosphor plate thus prepared, even when the more and the less volatile raw precursor materials are evaporated both from one and the same crucible unit.

Independent thereupon in a vapour deposition apparatus wherein the method according to the present invention is applied, said apparatus further has, in a preferred embodiment, three linear chimney heating elements (chimney heaters) mounted versus the chimney outlet, and positioned so that there is no direct path for vaporised particles from said raw materials to escape through the chimney slot outlet. Such an arrangement is more particularly required in order to avoid spatter of raw precursor materials, wherein the chimney heaters are acting as baffles. In another embodiment a refractory plate, e.g. a tantalum plate, is mounted internally in the crucible under the baffling chimney heaters. Said crucible and said plate is further mounted between an electrode pair, in order to provide further homogeneous heating over the whole heat-conducting assembly, in favour of homogeneous deposition of phosphor or scintillator material.

In a vapour deposition apparatus wherein the method according to the present invention is applied, said (controllable) slot outlet (3') is a rectangular slot outlet as illustrated in Fig.1. It is a particular advantage that in a vapour deposition apparatus wherein the method according to the present invention is applied, said linear chimney heating elements (1) - see same Fig. 1 - are movable in an upward or downward position.

In the case wherein the vapour deposition apparatus provides ability for one carrier roller to rotate, in a controlled way, by means of a motor around its axis, whereas other roller(s) is(are) rotating by movement of said one roller; and wherein, while rotating, the position of the flexible substrate on the rollers is controlled by means of an optical positioning sensor, coupled back to pressure regulating cylinder(s), providing position adjustment of said flexible substrate, the phosphor layer is prepared in a continuous vapour depositing process as described in US-A's 2004/0219289 and in 2004/0224084.

In another embodiment said substrate is rotating around an axis parallel with or inclined at a well-defined angle versus the vapour stream escaping from the crucible unit(s) present in the batch vapour deposition apparatus. Alternatively the substrate or support may be at a fixed position, whereas the crucible unit(s) may be rotated around a virtual axis parallel with or inclined at a well-defined angle versus an axis perpendicular to said support or substrate.

As a substrate material whereupon the scintillator or phosphor material is deposited in the vapour depositing apparatus according to the method of the present invention, use can be made of glass, a ceramic material, a polymeric material or a metal; more preferably a material selected from the group consisting of glass, polyethylene therephthalate, polyethylene naphthalate, polycarbonate, polyimide, carbon fibre-reinforced plastic sheets, aluminum, Pyrex^{®}, polymethylacrylate, polymethylmethacrylate, sapphire, zinc selenide, Zerodur^{®}, a ceramic layer and a metal or an alloy selected from the group of aluminum, steel, brass, titanium and copper. It should even not be limited thereto as in principle, any metal or synthetic material resisting irreversible deformation, e.g. as by melting, after addition of energy to the extent as commonly applied in the coating process of the present invention, is suitable for use. Particularly preferred as flexible substrate in method of the present invention is aluminum as a very good heat conducting material allowing a perfect homogeneous temperature over the whole substrate. As particularly useful aluminum substrates, without however being limited thereto, brightened anodised aluminium, anodised aluminium with an aluminium mirror and an oxide package and, optionally, a parylene layer; and anodised aluminium with a silver mirror and an oxide package and, optionally, a parylene layer; available from ALANOD, Germany, are recommended. So, as a preferred, flexible substrate support an anodised aluminum support layer, covered with a protective foil, is recommended. Such an anodised aluminum support layer may have a thickness in the range of from 50 to 500 µm, and more preferably in the range from 200 to 300 µm. Such an anodised aluminum substrate has shown to be particularly favorable indeed with respect to adhesion characteristics with respect to vapour deposited phosphors or scintillators and even bending of that flexible aluminum support coated with a scintillator layer having a thickness of 500 µm up to 1000 µm, does not cause "cracks" or delamination of scintillator or phosphor "flakes". No problems have indeed been encountered with respect to occurrence of undesirable cracks when prepared in the vapour deposition apparatus wherein the method of the present invention is applied.

While vapour deposition proceeds the temperature of the said substrate is maintained in the range from 150°C to 300°C, more preferably in the range from 150°C to 250°C and still more preferably in the range from 180°C to 220°C, envisaging a target temperature of about 200°C, by means of adjustable heaters and by an addressable cooling unit installed along the support. As heaters, infrared heaters are advantageously used. More particularly use is made of large quartz lamps, arranged horizontally, e.g. longitudinally, along the said substrate with a reflecting screen behind it.

It is evident that the composition of the raw material in the container(s) (crucible(s)) of the vapour depositing apparatus wherein the method of the present invention is applied, is chosen in order to provide an end composition or coating composition as desired, wherein said composition is determined by the ratios of raw materials present. Ratios of raw materials are chosen in order to provide the desired chemical composition of the phosphor or scintillator after deposition of the vaporised raw materials. It is desirable to mix the raw materials in order to get a homogeneous raw mix in the crucible(s) in form of solid powders, grains or granules, or as pastilles having a composition corresponding with the desired ratios of raw materials in order to provide the desired phosphor coated onto the moving substrate material. A milling procedure may be favourable in order to provide a high degree of homogeneity before vaporisation and is therefore recommended. Differing components may also be vaporised from different crucibles, arranged in series or in parallel or in a combined arrangement as already suggested before, provided that a homogeneous vapour cloud is presented to the flexible substrate via the vapour stream or flow, deposited by condensation onto said substrate. Two elongated one-part boats having same or different raw material content or raw material mixtures may e.g. be present in series in the moving direction of the web. In another embodiment, if providing a more homogeneous coating profile, boats may be arranged in parallel on one axis or more axes, perpendicular to the moving direction of the support, provided that overlapping evaporation clouds again are providing a vapour stream that becomes deposited onto the support in a phosphor or scintillator layer having a homogeneous thickness, composition and coated amount of said phosphor or scintillator. Presence of more than one crucible may be in favour of ability to supply greater amounts of phosphor or scintillator material to be deposited per time unit, the more when the flexible substrate should pass the vapour flow at a rate, high enough in order to avoid too high temperature increase of the substrate. The velocity or rate at which the substrate passes the container(s) should indeed not be too slow in view of undesired local heating of the substrate support, making deposition impossible, unless sufficient cooling means are present in favour of condensation. The supporting or supported substrate should therefore preferably have a temperature between 50°C and 300°C in order to obtain deposited phosphor or scintillator layers having the desired optimised properties.

It is clear that energy should be supplied to one or more container(s), also known as crucible(s), tray(s) or boat(s), in order to provoke a vapour flow (or stream) of the raw materials present therein, which become vaporised in the sealed vacuum zone: energy is submitted thereto by thermal, electric, or electromagnetic energy sources. As an example of an electromagnetic energy source a diode, a cathode arc, a laser beam, an electron beam, an ion beam, magnetron radiation or radio frequencies may be used, whether or not pulsed, without however being limited thereto. Electric energy is commonly provided by resistive heating, making use of resistance coils wound around the container(s) or crucible(s) in a configuration in order to get conversion into thermal energy, thereby providing heat transfer to the containers or crucibles filled with the raw materials that should be evaporated. Energy supply to an extent in order to heat the container(s) or crucible(s) up to a temperature in the range from 550°-900°C is highly desired. At those temperatures, it is clear that containers should resist corrosion, so that refractory containers are preferred. Preferred container or crucible materials therefore are tungsten, tantalum, molybdenum and other suitable refractory metals. Energy supply as set forth heats the mixture of raw materials in the crucible to a temperature above 450°C, preferably above 550°C, and even more preferably in the range of 550°C up to 900°C, e.g. at about 700°C.

A cloud of vaporised material, originating from the target raw materials thus escapes as a cloud in form of a flow or stream from the container(s) or crucible(s) in the direction of the moving substrate, whereupon a coated layer is formed by condensation. From the description above it is clear that, in order to obtain a homogeneous coating profile as envisaged, a homogeneous cloud can only be realised when homogeneity is provided in the bulk of the liquefied raw material. As a consequence, a homogeneous distribution of energy supplied over the container is a stringent demand. In a preferred embodiment, in favour of homogeneity, the crucible is in form of a single elongated "boat" with a largest dimension corresponding with the width of the flexible support moving over the said crucible so that at each point of its surface area the momentarily velocity magnitude is constant. If required during or after the deposition process oxygen can be introduced into the vacuum deposition chamber in form of oxygen gas via an inert (argon) gas inlet. More particularly an annealing step in between two deposition steps or at the end of the phosphor deposition may be beneficial.

An important factor with respect to coating profile, to be obtained on the substrate support in the vapour depositing apparatus wherein the method of the present invention is applied, is the distance between container(s) and moving substrate as the distance determines the profile of the vapour cloud at the position of the flexible substrate. Average values of shortest distances between crucible(s) and substrate may be in the range of from 5 to 10 cm, although further distances up to 20-25 cm are not excluded as favouring temperature control of the substrate. Too large distances may lead to loss of material and decreased yield of the process, whereas too small distances may lead to too high a temperature of the substrate. Moreover care should further be taken with respect to avoiding "spot errors" or "pits", resulting in uneven deposit of phosphors or scintillators, due to spitting of the liquefied raw materials present in the heated container(s). Measures taken therefore have been illustrated in Fig.1 and, more in detail in Fig. 1B, more particularly with lamps used as baffles, and more preferably with three linear chimney heating elements, mounted versus the slot outlet and positioned so that there is no direct path for vaporised particles from said raw materials to escape through said slot outlet.

In the vapour depositing apparatus wherein the method of the present invention is applied, vapour deposition of said phosphor or scintillator compositions is initiated by a vapour flow of raw materials from one or more crucible(s), wherein said vapour flow is generated by adding energy to said raw materials and said container(s), by thermal, electric, or electromagnetic energy or a combination thereof. So vapour depositing said phosphor or scintillator compositions advantageously proceeds by physical vapour deposition, by chemical vapour deposition or a by combination of physical and chemical vapour deposition.

The preferred CsBr:Eu phosphor, obtained after vapour deposition as a needle-shaped phosphor in the vapour depositing apparatus wherein the method of the present invention is applied, is characterised by voids between the needles. In order to fill those voids, measures can be taken as described in US-Application 2003/0168611, wherein voids are partially filled with a polymeric compound; as in US-Application 2003/0183777, wherein vapour deposited pigments like the preferred β-Cu-phthalocyanine nanocrystalline dye compound are filling said voids or as in US-Application 2004/0228963, wherein the voids are at least partially filled with polymeric compounds selected from the group consisting of silazane and siloxazane type polymeric compounds, mixtures thereof and mixtures of said silazane or siloxazane type polymeric compounds with compatible polymeric compounds. More particularly with respect to the said dyes or pigments, vapour deposition thereof can be performed in the vacuum deposition chamber used in the configuration of the production method according to the present invention.

At the moment of deposition, a preferred stimulable phosphor or scintillator layer, prepared in the vapour depositing apparatus wherein the method of the present invention is applied, is a binderless layer. This can be well understood, as at those high temperatures, presence of additional binders besides phosphors or scintillators raw materials in the container(s) would not be practical. It is however not excluded to make use of polymers, showing ability to become vaporised, in order to serve as binder material e.g. between substrate and phosphor or scintillator layer or even between the preferred phosphor or scintillator needles in the coated layer. Moreover when laminating a polymer layer onto the deposited layer, it is not excluded that polymer material is filling, at least in part, the voids between those needles. Furtheron it is not excluded to provide the phosphor or scintillator sheets or panels, before or after cutting in desired formats, with a moisture-resistant layer, in order to protect the moisture-sensitive phosphor layer against deterioration. Particularly preferred layers are e.g. parylene (p-xylylene) layers as described in US-A 6,710,356, whether or not overcoated with a transparent organic layer of silazane or siloxazane type polymeric compounds or mixtures thereof as described in US-Application 2004/0164251. In the method of applying a protecting parylene layer to phosphor or scintillator coatings as a "parylene layer" a halogen-containing layer was preferred. More preferably said "parylene layer" is selected from the group consisting of a parylene D, a parylene C and a parylene HT layer. In the particular case a cross-linked polymeric layer is advantageously formed on a phosphor screen material, wherein the said polymeric material layer has been formed by reaction of at least one component, thereby forming self-condensing polymers. Reactive monomers are provided in form of heated vapour in order to form the desired condensation polymer on the substrate, wherein said condensation polymer is in form of a p-xylylene or "parylene" layer on the phosphor screen substrate. Examples of these "parylene" layers are poly-p-xylylene (Parylene-N), poly-monochloro-p-xylylene (Parylene-C) and polydichloro-p-xylylene (Parylene-D). A pigment may be present in a thin film of a poly-p-xylylene as in JP-A 62-135520.

Apart from a stimulable phosphor layer, a prompt emitting luminescent phosphor can be coated in the vapour depositing apparatus wherein the method of the present invention is applied. Such a luminescent phosphor is then suitable for use e.g. in intensifying screens as used in screen/film radiography.

Although by the method of the present invention a substantially improved intrinsic humidity stability is attained (expressing its stability in the absence of any protective layer or coating), in a further step of the method according to the present invention said phosphor layer is coated with a protective layer. It is advantageous to provide said storage phosphor panel according to the present invention with a polymer layer, and, more preferably with a protecting layer. More particularly a poly p-xylylene or "parylene" layer is desired. In another embodiment the storage phosphor panel is provided with an intermediate layer between phosphor layer and support. Preferred is a polymer layer, and even more preferred as being particularly suitable for use as a moisture protecting layer is a poly p-xylylene or "parylene" layer, not only from a point of view of protection against humidity, but also from a point of view of protection against damaging. Such externally applied organic layers have e.g. been described in EP-A 1 286 364 and corresponding US-P 6,710,356, whether or not in contact with a transparent organic layer of silazane or siloxazane type polymeric compounds or mixtures thereof as described in EP-A's 1 453 065 and 1 453 066 and corresponding US-Applications 2004/0228963 and 2004/0164251, offering further protection against scratches.

With respect to specific applications, related with CR and DR, it is clear that in view of image quality, and more particularly in view of sharpness, binderless phosphor or scintillator layers as described hereinbefore are preferred. With respect thereto it is clear that vaporisation of raw materials in the vapour depositing apparatus wherein the method of the present invention is applied, in order to build the desired scintillator or phosphor layers is a preferred technique, provided that the layers have been deposited on a flexible substrate, wherein it is envisaged to deform the flexible support in order to get a flat sheet or panel, ready-for-use, suitable for specific CR and DR applications. Other hygroscopic phosphor or scintillator layers besides the preferred CsBr:Eu phosphor that are advantageously prepared according to the method of the present invention are e.g. BaFCl:Eu, BaFBr:Eu and GdOBr:Tm, used in intensifying screens; CsI:Na applied in scintillator panels and storage phosphors suitable for use in computed radiography (CR) as e.g. BaFBr:Eu, BaFI:Eu, (Ba,Sr)F(Br,I):Eu, RbBr:Tl, CsBr:Eu, CsCl:Eu and RbBr:Eu; or CsI:T1, Lu₂O₂S:xM and Lu₂O₅Si:xM, wherein M is selected from the group of rare earth elements consisting of Eu, Pr and Sm and wherein x is from 0.0001 to 0.2, which is particularly suitable for use in DR-cassettes as disclosed in US-Applications 2004/0262536 and 2005/0002490 respectively.

### Examples

While the present invention will hereinafter be described in connection with preferred embodiments thereof, it will be understood that it is not intended to limit the invention to those embodiments.

### Example 1

A CsBr:Eu photostimulable phosphor screen having a flexible anodised aluminum was prepared in a vacuum chamber by means of a thermal vapour deposition process, starting from a mixture of CsBr and EuOBr as raw materials. Said deposition process onto said flexible anodised aluminum support was performed in such a way that said support was rotating so that the momentary magnitude of the velocity was constant at each point of its area.

An electrically heated oven and a refractory tray or boat (4) in which 160-200 g (in one or more addition stages or steps, more additions performed in multi-evaporations) of a mixture of CsBr and EuOBr as raw materials in a 99.5%/0.5% CsBr/EuOBr percentage ratio by weight were present to become vaporised.

Crucible (4) - see Fig. 1 - was an elongated boat having a length of 60 mm, a width of 45 mm and a height of 40 mm composed of "tantalum" having a thickness of 0.5 mm, composed of 3 integrated parts: a crucible container (4), an internally heated chimney (2) and a chimney inlet (3) and a controllable slot outlet (3'). The longitudinal parts are folded from one continuous tantalum base plate in order to overcome leakage and the head parts are welded.

Under vacuum pressure (a pressure of 2 x 10⁻¹ Pa equivalent with 2 x 10⁻³ mbar) maintained by a continuous inlet of argon gas into the vacuum chamber, and at a sufficiently high temperature of the vapour source (760°C) and the chimney the obtained vapour was directed towards the moving sheet support and was deposited thereupon successively while said support was rotating over the vapour stream. Said temperature of the vapour source was measured by means of thermocouples present outside and pressed under the bottom of said crucible and tantalum protected thermocouples present in the crucible and in the chimney.

The anodised aluminum substrate support having a thickness of 280 µm, a width of 10 cm and a length of 10 cm, was positioned at the side whereupon the phosphor should be deposited at a distance of 22 cm between substrate and crucible vapour outlet slit.

Plates were taken out of the vapour deposition apparatus after having run different vapour deposition times, leading to phosphor plates having phosphor layers of different thicknesses (wherein as a function of thickness - vaporisation of raw material and transformation into phosphor building blocks - it was required to start adding extra raw material in order to be able to continue the process and to prepare thicker phosphor layers).

For each of the layers the Eu-dopant amounts (expressed as p.p.m. amounts - µgram per gram), the product of coated weight amounts of the phosphor and Europium dopant ("activator coating weight number" ACWN) and speed (SAL%) as well as loss in speed between the freshly prepared, non-protected panel and the same panel after a conditioning procedure, without any protective layer thereupon, in a room at a temperature of 30°C and a relative humidity of 80%, during a time of 140 hours.

The data mentioned above have been set out in the Table 1, wherein relative speed (SAL%) is defined as the speed of each of the screens compared with the reference speed of an MD10^{®} reference photostimulable phosphor screen manufactured by Agfa-Gevaert, Mortsel, Belgium.

**Table 1**

| No. CB-plate | Add 1 | Add 2 | Eu p.p.m. | Coat. weight mg/cm² | ACWN | SAL% | SAL%decay after 140 h 30°C/80%RH |
|---|---|---|---|---|---|---|---|
| 22602 | 180 | - | 98.2 | 70.8 | 6953 | 264 | 85 |
| 22711 | 160 | - | 299 | 87.2 | 26073 | 395 | 14 |
| 22705 | 80 | 80 | 373 | 70.8 | 26408 | 341 | 10 |
| 22801 | 160 | 160 | 397 | 161.7 | 64195 | 546 | 12 |

It is clear from the Table 1 that the lowest loss in speed (% decay of %SAL value) - also giving rise to the highest attainable speed after severe conditioning circumstances mentioned above - is found for the thickest plate - highest coating weight - which simultaneously has the highest Eu-dopant amount.

It is concluded that a higher coating weight and a higher amount of dopant or activator provide the best compromise, or otherwise expressed: for the highest value of the "activator coating weight number", to be calculated as the product of phosphor coating weight - expressed in mg/cm² - and concentration of activator in the panel versus matrix - expressed in p.p.m. (µg/g).

It is further concluded that a multi-evaporation step, by adding a second amount of raw precursor materials is advantageous, not only as it allows an increased phosphor coating amount (compare CB22801 with CB22705), but as it unexpectedly leads to an increased activator dopant amount (compare CB22705 - 2 adding steps - with CB22711 - only 1 adding and thus only 1 evaporation step instead of 2).

In the Table 1 a value for the "activator coating weight number" ACWN in the range from 20,000 to 30,000 is attained for a panel having an amount of Eu-dopant of about 300-400 p.p.m., and said ACWN is even more than 60,000 for a panel having a phosphor coating weight of about 160 mg/cm² wherein that panel is very suitable for use in general radiography as its intrinsic stability is sufficient and satisfactory - otherwise expressed as loss in speed is extremely low, i.e. lower or at most about 15 % - after a conditioning procedure in rather severe circumstances of temperature (30°C) and relative humidity (80%RH), in the absence of a protective layer, as e.g. poly-paraxylylene or parylene, providing protection against ambient atmospheric moisture.

Fig. 2 clearly illustrates the differences in decay percentages as a function of ACWN in the circumstances set out hereinbefore.

It is clear that such phosphor plates, when covered with a protective coating as e.g. a poly-p-xylylene coating layer, known as "parylene", has a long lasting life-time, more particularly with respect to humidity stability. Moreover it is clear that, depending on application types in radiography where such a plate providing an excellent speed to sharpness relation is looked for, the choice of the thickness of the plate or panel is of primary interest as both said speed and said sharpness obtainable with a dedicate plate are decisive for the result obtained in the computed radiographic images after having read out said phosphor plate after having captured a minimised X-ray dose as a result of exposure of a patient.

### Example 2

A CsBr:Eu photostimulable phosphor screen having a flexible anodised aluminum was prepared in a vacuum chamber by means of a thermal vapour deposition process, starting from a mixture of CsBr and EuOBr as raw materials. Said deposition process, performed as disclosed in EP 1 460 642 A1 onto said flexible anodised aluminum support was performed in such a way that said support was rotating so that the momentary magnitude of the velocity was constant at each point of its area.

An electrically heated oven and a refractory tray or boat in which 300 g of a mixture of CsBr and EuOBr as raw materials in a 99.5%/0.5% CsBr/EuOBr percentage ratio by weight were present to become vaporised.

As a crucible use was made of an elongated boat having a length of 100 mm, a width of 35 mm and a height of 45 mm, composed of "tantalum" having a thickness of 0.5 mm. The 3 integrated parts thereof are: a crucible container, an internally heated chimney and a controllable outlet. The longitudinal parts were folded from one continuous tantalum base plate in order to overcome leakage and the head parts were welded.

Under vacuum pressure (a pressure of 2 x 10⁻¹ Pa equivalent with 2 x 10⁻³ mbar) maintained by a continuous inlet of argon gas into the vacuum chamber, and at a sufficiently high temperature of the vapour source (760°C) and the chimney the obtained vapour was directed towards the moving sheet support and was deposited thereupon successively while said support was rotating over the vapour stream. Said temperature of the vapour source was measured by means of thermocouples present outside and pressed under the bottom of said crucible and tantalum protected thermocouples present in the crucible and in the chimney. The anodised aluminum substrate support having a thickness of 280 µm, a width of 10 cm and a length of 10 cm was positioned at the side whereupon the phosphor should be deposited at a distance of 195 mm between substrate and crucible vapour outlet slit.

Plates were taken out of the vapour deposition apparatus after having run different vapour deposition times, leading to phosphor plates having phosphor layers of different thicknesses (wherein as a function of thickness - vaporisation of raw material and transformation into phosphor building blocks - it was required to start adding extra raw material in order to be able to continue the process and to prepare thicker phosphor layers). For each of the layers the thickness was measured, Eu-dopant amounts (expressed as p.p.m. amounts - µgram per gram), the product of coated weight amounts of the phosphor and Europium dopant ("activator coating weight number" ACWN) and speed (SAL%) as well as loss in speed (% decay of SAL) between the freshly prepared, non-protected panel and the same panel after a conditioning procedure, without any protective layer thereupon, in a room at a temperature of 35°C and a relative humidity of 80%, during a time of 140 hours (more severe circumstances).

The data mentioned above have been set out in the Table 2, wherein relative speed (SAL%) is defined as the speed of each of the screens compared with the reference speed of an MD10^{®} reference photostimulable phosphor screen manufactured by Agfa-Gevaert, Mortsel, Belgium.

**Table 2**

| Plate No. | Coating Weight mg/cm2 | Eu amt. g/kg | ACWN | SAL% rel. 21°C/ 50%RH | SAL% rel. 104h 35°C/ 80%RH | SAL %decay 104h 35°C/80 %RH |
|---|---|---|---|---|---|---|
| CB71303 | 72.1 | 53 | 3823 | 213 | 85 | 60.1 |
| CB71812 | 82.1 | 72 | 5913 | 207 | 103 | 50.2 |
| CB71903 | 82.1 | 45 | 3694 | 198 | 73 | 63.1 |
| CB71006 | 77.6 | 95 | 7374 | 215 | 158 | 26.5 |
| CB71106 | 76.9 | 123 | 9395 | 206 | 150 | 27.2 |
| CB71009 | 70.2 | 161 | 11309 | 175 | 139 | 20.6 |

From the data summarised in the Table 2 it is concluded that for about a same phosphor coating thickness of 200 µm the highest europium amount provides the most stabile phosphor plates in the absence of a protective waterproof coating: from a value of the product of Eu-content and coating weight of 7000 stability of the plates is satisfying. This has further been illustrated in Fig. 3, wherein speed decay percentages as measured for storage phosphor screens with CsBr:Eu phosphor layers even after severe conditioning during 104 hours in an atmosphere of 35°C and a relative humidity of 80% as a function of the product of Europium activator amount (in p.p.m.) and coated weight (in mg/cm²) for an unprotected CsBr:Eu needle-shaped phosphor layer, vapour deposited onto a support of a storage phosphor plate of panel are showing an acceptable, stabilised or constant decay of speed as soon as the "activator coating weight number" exceeds a value of 7,000.

Although a thinner storage phosphor layer as for mammographic applications, if compared, e.g. with general radiographic applications, is more sensitive to speed instability or inhomogeneity over a storage phosphor plate of the type discussed hereinbefore, it is understood that application of the teachings of the present invention leads to an at least equal to an even better stability or homogeneity than obtained for thicker storage phosphor layers as required in general radiographic applications.

### Example 3

A CsBr:Eu photostimulable phosphor screen having a flexible anodized aluminum was prepared in a vacuum chamber by means of a thermal vapor deposition process, starting from a mixture of CsBr and EuOBr as raw materials. Said deposition process onto said flexible anodized aluminum support was performed in such a way that said support was rotating so that the momentary magnitude of the velocity was constant at each point of its area.

An electrically heated oven and a refractory tray or boat in which 160-200 g of a mixture of CsBr and EuOBr as raw materials in a 99.5%/0.5% CsBr/EuOBr percentage ratio by weight were present to become vaporised.

As a crucible use was made of an elongated boat having a length of 60 mm, a width of 45 mm and a height of 40 mm, composed of "tantalum" having a thickness of 0.5 mm. The 3 integrated parts thereof are: a crucible container, an internally heated chimney and a controllable outlet. The longitudinal parts were folded from one continuous tantalum base plate in order to overcome leakage and the head parts were welded.

Under vacuum pressure (a pressure of 2 x 10⁻¹ Pa equivalent with 2 x 10⁻³ mbar) maintained by a continuous inlet of argon gas into the vacuum chamber, and at a sufficiently high temperature of the vapor source (760°C) and the chimney the obtained vapor was directed towards the moving sheet support and was deposited thereupon successively while said support was rotating over the vapor stream. Said temperature of the vapor source was measured by means of thermocouples present outside and pressed under the bottom of said crucible and tantalum protected thermocouples present in the crucible and in the chimney.

The anodized aluminum substrate support having a thickness of 280 µm, a width of 10 cm and a length of 10 cm, was positioned at the side whereupon the phosphor should be deposited at a distance of 22 cm between substrate and crucible vapour outlet slit.

Plates were taken out of the vapour deposition apparatus after having run different vapour deposition times, leading to phosphor plates having phosphor layers of different thicknesses (wherein as a function of thickness - vaporisation of raw material and transformation into phosphor building blocks - it was required to start adding extra raw material in order to be able to continue the process and to prepare thicker phosphor layers).

For each of the CsBr:Eu layers the coating weight was determined, Eu-dopant amounts (expressed as p.p.m. amounts - pg/g), the product of coated weight amounts of the phosphor and Europium dopant ("activator coating weight number" or ACWN) and speed (SAL%) as well as loss in speed between the freshly vapour deposited, non-protected phosphor layer of the panel and the same panel after a conditioning procedure, without any protective layer thereupon, in a room at a temperature of 35°C and a relative humidity of 80%, during a time of 140 hours.

The data mentioned above have been set out in the Table 3, wherein relative speed (SAL%) is defined as the speed of each of the screens compared with the reference speed of an MD10^{®} reference photostimulable phosphor screen manufactured by Agfa-Gevaert, Mortsel, Belgium, and wherein loss in speed is calculated from percentage differences of relative speed values SAL% are calculated from fresh and aged or conditioned panels.

When only for "Add 1" an amount, expressed in gram of raw material mixture is given, it means that no multi-evaporation takes place. If however also for "Add 2" an amount, expressed in gram of raw material mixture is given, this expresses that a multi-evaporation step is applied.

**Table 3**

| No. CB-plate | Add 1 (g) | Add 2 (g) | Eu p.p.m | Layer thickn. (µm) | Coat. weight mg/cm² | ACWN | SAL% rel. | SAL: %decay after 140 h 30°C/80%RH |
|---|---|---|---|---|---|---|---|---|
| 22505 | 22 | - | 56 | 1 | 2.9 | 162 | 2 | 100 |
| 22506 | 45 | - | 89 | 23 | 13 | 1157 | 42 | 95 |
| 22507 | 90 | - | 169 | 108 | 28.5 | 4816 | 124 | 76 |
| 22601 | 135 | - | 133.5 | 109 | 44 | 5874 | 178 | 85 |
| 22602 | 180 | - | 98.2 | 184 | 70.8 | 6953 | 264 | 85 |
| 22711 | 160 | - | 299 | 228 | 87.2 | 26072 | 395 | 14 |
| 22705 | 80 | 80 | 373 | 368 | 70.8 | 26408 | 341 | 10 |
| 22801 | 160 | 160 | 397 | 422 | 161.7 | 64194 | 546 | 12 |

As can be concluded from the data in the Table 3, an intrinsic stability of the Eu-doped phosphor layer (without protection layer) against moisture is only attained if in the thicker phosphor layers having a phosphor layer thickness of more than 200 µm high enough a dopant or activator concentration, i.e., in the range from about 300 p.p.m. to about 400 p.p.m. is present.

Only in the inventive coatings (CB22711, CB22705 and CB22801) without protective layer an "activator coating weight number" (ACWN) of more than 20,000 is effectively attained, resulting in an intrinsic humidity stability as envisaged. Loss in speed (SAL%), expressed as decay percentage after 140 h at 30°C and 80%RH, is clearly reduced to less than 20%, and even less than 15% as illustrated in Fig. 4.

### Example 5

In another electrically heated oven and a refractory tray or boat in which 600 g of a mixture of CsBr and EuOBr as raw materials in a 99.5%/0.5% CsBr/EuOBr percentage ratio by weight were present to become vaporised. As a crucible use was made of an elongated boat having a length of 150 mm, a width of 60 mm and a height of 35 mm, composed of "tantalum" having a thickness of 0.5 mm.
The same procedure as in Example 4 was performed and results obtained for the CsBr:Eu phosphor plates thus prepared have been summarised in Table 4.

**Table 4**

| No. CB-plate | Eu p.p.m | Coat. weight mg/cm² | ACWN | SAL% rel. | SAL: %decay after 140 h 35°C/80%RH |
|---|---|---|---|---|---|
| 51814 | 458 | 208.9 | 95667 | 644 | 23.9 |
| 51906 | 443 | 188.4 | 83466 | 479 | 21.5 |
| 51908 | 418 | 179.5 | 75010 | 406 | 16.5 |
| 52303 | 228 | 176.3 | 40190 | 535 | 40.4 |
| 51921 | 152 | 194.6 | 29584 | 767 | 62.3 |
| 51835 | 68 | 191.1 | 12995 | 740 | 91.9 |

It is clear from the Table 4 that in order to intrinsically stabilise thick (ca. 200 mg/cm²) unprotected phosphor layers, it is necessary to build in huge amounts of activator or dopant (ca. 400 p.p.m. and even more) in order to reduce loss in speed to less than 25%, after a severe conditioning at 35°C and 80%RH, during 140 hours. More severe circumstances tend to lead to an increased loss of speed, but can nevertheless be reduced when thicker layers having been doped with more dopant or activator have been coated, resulting in a high ACWN exceeding a value of 70,000 and even up to about 100,000. Figures of decay percentages in circumstances as set forth above have been plotted in Fig. 5 versus ACWN values.

Although a thicker storage phosphor layer dedicated for use in general radiography is expected to be more stable with respect to sensitivity and homogeneity over said storage phosphor plate from a point of view of physical morphology, it is understood that enough activator component should indeed be built in, even in a thicker plate suitable for use in general radiography, in order to have a stability that is comparable with that of a thinner phosphor layer in a storage phosphor plate as used e.g. for mammographic applications.

### PARTS LIST

(1) chimney heaters
(2) internally heated chimney
(3) chimney inlet (3') chimney slot outlet
(4) crucible, tray or boat. ■

## Claims

1. Method of preparing a storage phosphor panel having a phosphor layer coated onto a dedicate substrate by vapour depositing raw phosphor precursor materials comprising a matrix component, an activator component and/or a combination thereof from one or more crucible unit(s) in a vapour deposition apparatus, wherein a crucible unit comprises a crucible container and a vaporisation chimney;
wherein said method comprises the steps of (1) adding said raw phosphor precursor materials to said crucible unit, and (2) vapour depositing a phosphor layer from said raw phosphor precursor materials, wherein vapour depositing proceeds at an increased temperature in the crucible unit, said temperature exceeding the melting temperature of said matrix raw material with more than 70° C; **characterised in that** an "activator coating weight number" for said phosphor layer reaches a value of at least 7,000;
wherein said "activator coating weight number" is defined as the product of the average activator amount present in said phosphor layer, said amount being expressed in p.p.m. ( µg/g) of activator versus matrix component, and weight of coated phosphor in said phosphor layer, expressed in mg/cm², and wherein enhancing said temperature in the vaporisation chimney of the crucible unit versus in the crucible containing raw material precursor(s) proceeds by the step of heating said raw precursor materials in the boat or crucible in liquid form up to a temperature T1 and by heating said raw material precursor(s) in vaporised form in said chimney up to a temperature T2 and wherein a positive difference in temperature [T2 - T1] is maintained.

2. Method according to claim 1, wherein an average activator amount present in said phosphor layer is at least 70 p.p.m.

3. Method according to claim 1 or 2, wherein said weight of coated phosphor is less than 100 mg/cm² and wherein said phosphor layer has an average thickness of less than 200 µm.

4. Method according to claim 1 wherein the "activator coating weight number" for said phosphor layer reaches a value of at least 20,000.

5. Method according to claim 4, wherein the "activator coating weight number" reaches a value of more than 40,000.

6. Method according to claim 4, wherein the "activator coating weight number" reaches a value of more than 60,000.

7. Method according to any one of the claims 4 to 6, wherein the average activator amount present in said phosphor layer is at least 200 p.p.m.

8. Method according to any one of the claims 4 to 7, wherein said weight of coated phosphor is at least 100 mg/cm² and wherein said phosphor layer has an average thickness of at least 200 µm.

9. Method according to any one of the claims 1 to 8, wherein a multievaporation step is performed by replenishing said crucible(s) without a cleaning step inbetween.

10. Method according to any one of the claims 1 to 9, wherein said raw material precursor is CsX as a matrix component and EuX2, EuX3, EuOX or a mixture thereof as activator components, X representing Cl, Br, I or a combination thereof.

11. Method according to any one of the claims 1 to 9, wherein said raw precursor material is CsxEuyX'(x+αy), wherein x, y and α are integers, wherein x/y is more than 0.25 and wherein α is at least 2 and wherein X' represents Cl, Br, I or a combination thereof.

12. Method according to any one of the claims 1 to 9, wherein said storage phosphor is CsBr: Eu.

13. Method according to any one of the claims 1 to 12, wherein vapour depositing proceeds in a batch process.

14. Method according to any one of the claims 1 to 12, wherein said vapour depositing proceeds in a continuous process.

## Patentansprüche

1. Verfahren zur Herstellung einer Speicherleuchtstoffplatte mit einer Leuchtstoffschicht, die durch Aufdampfen von Rohmaterialen einer Leuchtstoffvorstufe, die eine Matrixkomponente, eine Aktivatorkomponente und/oder eine Kombination derselben umfassen, aus einer oder mehreren Tiegeleinheiten in einem Aufdampfapparat auf ein geeignetes Substrat aufgetragen ist, wobei eine Tiegeleinheit einen Tiegelbehälter und ein Verdampfungssteigrohr Aufdampfleitung umfasst, wobei das Verfahren folgende Schritte umfasst : (1) Einfüllen der Rohmaterialien der Leuchtstoffvorstufe in die Tiegeleinheit und (2) Aufdampfen einer Leuchtstoffschicht aus den Rohmaterialien der Leuchtstoffvorstufe, wobei das Aufdampfen bei erhöhter Temperatur in der Tiegeleinheit erfolgt und die Temperatur um mehr als 70°C oberhalb der Schmelztemperatur des Matrixrohmaterials liegt, **dadurch gekennzeichnet, dass** eine "Aktivatorauftragsgewichtszahl" für die Leuchtstoffschicht einen Mindestwert von 7.000 erreicht, wobei die "Aktivatorauftragsgewichtszahl" als das Produkt der mittleren Aktivatormenge in der Leuchtstoffschicht, wobei die Menge in ppm (µg/g) Aktivator, bezogen auf die Matrixkomponente, ausgedrückt wird, und des in mg/cm² ausgedrückten Auftragsgewichts des Leuchtstoffes in der Leuchtstoffschicht definiert wird, und wobei eine Erhöhung der Temperatur im Verdampfungssteigrohr der Tiegeleinheit, bezogen auf die Temperatur im eine oder mehrere Rohmaterialvorstufen enthaltenden Tiegel, im Schritt erfolgt, in dem die Vorstufenrohmaterialien im Schiffchen oder Tiegel in Flüssigform bis auf eine Temperatur T1 erhitzt werden und die Rohmaterialvorstufe(n) in Dampfform im Steigrohr bis auf eine Temperatur T2 erhitzt wird (werden), und wobei ein positiver Temperaturunterschied [T2 - T1] aufrechterhalten wird.

2. Verfahren nach Anspruch 1, **dadurch gekennzeichnet, dass** eine mittlere Aktivatormenge in der Leuchtstoffschicht bei mindestens 70 ppm liegt.

3. Verfahren nach Anspruch 1 oder 2, **dadurch gekennzeichnet, dass** das Auftragsgewicht des Leuchtstoffes bei weniger als 100 mg/cm² liegt und die Leuchtstoffschicht eine mittlere Stärke von weniger als 200 µm hat.

4. Verfahren nach Anspruch 1, **dadurch gekennzeichnet, dass** die "Aktivatorauftragsgewichtszahl" für die Leuchtstoffschicht einen Mindestwert von 20.000 erreicht.

5. Verfahren nach Anspruch 4, **dadurch gekennzeichnet, dass** die "Aktivatorauftragsgewichtszahl" einen Wert von mehr als 40.000 erreicht.

6. Verfahren nach Anspruch 4, **dadurch gekennzeichnet, dass** die "Aktivatorauftragsgewichtszahl" einen Wert von mehr als 60.000 erreicht.

7. Verfahren nach einem der Ansprüche 4 bis 6, **dadurch gekennzeichnet, dass** die mittlere Aktivatormenge in der Leuchtstoffschicht bei mindestens 200 ppm liegt.

8. Verfahren nach einem der Ansprüche 4 bis 7, **dadurch gekennzeichnet, dass** das Auftragsgewicht des Leuchtstoffes bei mindestens 100 mg/cm² liegt und die Leuchtstoffschicht eine mittlere Stärke von mindestens 200 µm aufweist.

9. Verfahren nach einem der Ansprüche 1 bis 8, **dadurch gekennzeichnet, dass** ein Schritt mit mehrfacher Verdampfung durch Nachfüllen des (der) Tiegel(s) ohne Zwischenreinigungsschritt vorgenommen wird.

10. Verfahren nach einem der Ansprüche 1 bis 9, **dadurch gekennzeichnet, dass** die Rohmaterialvorstufe CsX als Matrixkomponente und EuX₂, EuX₃, EuOX oder ein Gemisch derselben als Aktivatorkomponenten ist, wobei X Cl, Br, I oder eine Kombination derselben bedeutet.

11. Verfahren nach einem der Ansprüche 1 bis 9, **dadurch gekennzeichnet, dass** das Vorstufenrohmaterial CsₓEu_{y}X'(_{x+αy)} ist, wobei x, y und α ganze Zahlen sind, wobei x/y mehr als 0,25 beträgt und α mindestens 2 beträgt und X' Cl, Br, I oder eine Kombination derselben bedeutet.

12. Verfahren nach einem der Ansprüche 1 bis 9, **dadurch gekennzeichnet, dass** der Speicherleuchtstoff CsBr:Eu ist.

13. Verfahren nach einem der Ansprüche 1 bis 12, **dadurch gekennzeichnet, dass** die Aufdampfung batchweise erfolgt.

14. Verfahren nach einem der Ansprüche 1 bis 12, **dadurch gekennzeichnet, dass** die Aufdampfung ein kontinuierliches Verfahren ist.

## Revendications

1. Procédé pour la fabrication d'une plaque luminescente à mémoire comprenant une couche luminescente appliquée sur un substrat approprié par dépôt en phase gazeuse de matériaux de base d'un précurseur de luminophore comprenant un composant de matrice, un composant activateur et/ou une combinaison de ceux-ci, à partir d'une ou plusieurs unités de creuset dans un appareil de dépôt en phase gazeuse, une unité de creuset comprenant un conteneur de creuset et une conduite de vaporisation, ledit procédé comprenant les étapes consistant à : (1) charger l'unité de creuset des matériaux de base d'un précurseur de luminophore et (2) déposer en phase gazeuse une couche luminescente à partir des matériaux de base d'un précurseur de luminophore, le dépôt en phase gazeuse s'effectuant à température élevée dans l'unité de creuset et la température étant supérieure de plus de 70°C à la température de fusion du matériau de base de matrice, **caractérisé en ce qu'**un « nombre de poids d'activateur déposé pour la couche luminescente atteint une valeur minimale de 7.000, ledit « nombre de poids d'activateur déposé » étant défini comme le produit de la quantité moyenne d'activateur dans la couche luminescente, ladite quantité étant exprimée en ppm (µg/g) d'activateur par rapport au composant de matrice, et du poids de luminophore déposé exprimé en mg/cm² dans la couche luminescente, et l'augmentation de la température dans la conduite de vaporisation de l'unité de creuset, par rapport à la température dans le creuset contenant un ou plusieurs précurseurs de matériaux de base, s'effectuant par l'étape consistant à chauffer les matériaux de base de précurseur contenus sous forme liquide dans la nacelle ou le creuset à une température T1 et à chauffer le(s) précurseur(s) de matériaux de base sous forme vaporisée dans la conduite de vaporisation à une température T2, une différence de température positive [T2 - T1] étant maintenue.

2. Procédé selon la revendication 1, **caractérisé en ce qu'**une quantité moyenne d'activateur dans la couche luminescente s'élève à au moins 70 ppm.

3. Procédé selon la revendication 1 ou 2, **caractérisé en ce que** le poids de luminophore déposé est inférieur à 100 mg/cm² et que la couche luminescente présente une épaisseur moyenne inférieure à 200 µm.

4. Procédé selon la revendication 1, **caractérisé en ce que** le « nombre de poids d'activateur déposé » pour la couche luminescente atteint une valeur minimale de 20.000.

5. Procédé selon la revendication 4, **caractérisé en ce que** le « nombre de poids d'activateur déposé » atteint une valeur supérieure à 40.000.

6. Procédé selon la revendication 4, **caractérisé en ce que** le « nombre de poids d'activateur déposé » atteint une valeur supérieure à 60.000.

7. Procédé selon l'une quelconque des revendications 4 à 6, **caractérisé en ce que** la quantité moyenne d'activateur dans la couche luminescente s'élève à au moins 200 ppm.

8. Procédé selon l'une quelconque des revendications 4 à 7, **caractérisé en ce que** le poids de luminophore déposé s'élève à au moins 100 mg/cm² et que la couche luminescente présente une épaisseur moyenne minimale de 200 µm.

9. Procédé selon l'une quelconque des revendications 1 à 8, **caractérisé en ce qu'**il est effectué une étape à multiple évaporation en remplissant le(s) creuset(s) sans étape de nettoyage intermédiaire.

10. Procédé selon l'une quelconque des revendications 1 à 9, **caractérisé en ce que** le précurseur de matériaux de base est le CsX comme composant de matrice et le EuX₂, le EuX₃, le EuOX ou un mélange de ceux-ci comme composants activateurs, X étant Cl, Br, I ou une combinaison de ceux-ci.

11. Procédé selon l'une quelconque des revendications 1 à 9, **caractérisé en ce que** le matériau de base de précurseur est le CsₓEu_{y}X'(_{x+αy}) où x, y et α sont des nombres entiers, où x/y est supérieur à 0,25, où α s'élève à au moins 2 et où X' représente Cl, Br, I ou une combinaison de ceux-ci.

12. Procédé selon l'une quelconque des revendications 1 à 9, **caractérisé en ce que** le luminophore à mémoire est le CsBr:Eu.

13. Procédé selon l'une quelconque des revendications 1 à 12, **caractérisé en ce que** le dépôt en phase gazeuse s'effectue par lots.

14. Procédé selon l'une quelconque des revendications 1 à 12, **caractérisé en ce que** le dépôt en phase gazeuse s'effectue de façon continue.
